# EUROPEAN PATENT APPLICATION

(11) **EP 4 604 696 A1**
(43) Date of publication of application: **20.08.2025**
(21) Application number: 24186559.1
(22) Date of filing: 04.07.2024
(51) Int. Cl.: H10H 20/816, H10H 20/825, H10H 20/831

(54) **SEMICONDUCTOR DEVICE**

(30) Priority: 17.02.2024 TW 113105674
(71) Applicant: Taiwan-Asia Semiconductor Corporation, Hsinchu City 30078 (TW)
(72) Inventor: Cheng, Yu-Ling, Hsinchu City 30078 (TW); Hsieh, Po-Jen, Hsinchu City 30078 (TW)
(74) Representative: Michalski Hüttermann & Partner Patentanwälte mbB

(57) **Abstract**

A semiconductor device is provided. The semiconductor device comprises a substrate (10), an upper electrode (50), a first semiconductor layer (20), a light-emitting layer (30), a second semiconductor layer (40) and a plurality of conductive through holes (26). The second semiconductor layer (40), the light-emitting layer (30), the first semiconductor layer (20) and the upper electrode (50) are sequentially disposed on the substrate (10). The conductive through holes (26) are vertically disposed in the first semiconductor layer (20) so that the upper electrode (50) is electrically connected to the light emitting layer (30) through the conductive through holes (26).

## Description

### CROSS-REFERENCES TO RELATED APPLICATIONS

This application claims priority to Taiwan Patent Application No. 113105674 filed on February 17, 2024, which is hereby incorporated by reference in its entirety.

### BACKGROUND OF THE INVENTION

### Field of the Invention

The present invention relates to a semiconductor device, and in particular to a light-emitting diode with uniform current spreading.

### Descriptions of the Related Art

Light-emitting diodes (LEDs) of solid-state light-emitting devices have low power consumption, low heat production, long life, resistance to falling, small size, fast response, and good optoelectronic properties, such as stable luminescence wavelength, or the like. Thus, LEDs have been widely used in household devices, indicator lights and optoelectronic products. With the development of optoelectronic technology, solid-state light-emitting devices have made considerable progress in terms of luminous efficiency, operation life and brightness. LEDs have become the mainstream of future lighting devices.

The working principle of LEDs is to guide electrons and holes into the P-N junction region by applying a voltage between two different types of semiconductor materials. Current spreading enables these carriers to move from a high-concentration region to a low-concentration region, thereby achieving efficient carrier injection. When electrons and holes are injected into the P-N junction region, they will recombine in this region. This recombination process releases energy, which is the light emitted by the LEDs. Current spreading ensures that a large number of electrons and holes can meet in the light-emitting region for increasing the chance of carrier recombination and thereby enhancing luminous efficiency. If the carrier density is not uniform, only some regions will emit lights, which will lead to uneven light emission and color changes.

In order to overcome the above problems, the industry urgently needs an innovative light-emitting diode structure to improve the above-mentioned problem of poor current spreading in order to increase the brightness of the light-emitting diodes.

### SUMMARY OF THE INVENTION

The main objective of the present invention is to provide an innovative semiconductor device, especially a light-emitting diode, to improve the reduction of luminous efficiency, uneven luminescence, and uneven luminescence, color changes and other problems caused by uneven current distribution in conventional light-emitting diode devices in order to improve the brightness of light-emitting diodes.

To achieve the above objective, the present invention discloses a semiconductor device which comprises a substrate, an upper electrode, a first semiconductor layer, a light-emitting layer, a second semiconductor layer and a plurality of conductive through holes. The second semiconductor layer, the light-emitting layer, the first semiconductor layer and the upper electrode are sequentially disposed on the substrate. The conductive through holes are vertically disposed in the first semiconductor layer so that the upper electrode is electrically connected to the light emitting layer through the conductive through holes.

In one embodiment of the semiconductor device of the present invention, the upper electrode is electrically connected to the light emitting layer through the conductive through holes.

In one embodiment of the semiconductor device of the present invention, the semiconductor device further comprises a current spreading composite layer, sandwiched in the first semiconductor layer. The conductive through holes vertically penetrate the current spreading composite layer.

In one embodiment of the semiconductor device of the present invention, the conductive through holes are vertically disposed in an edge region or an inner region of the first semiconductor layer.

In one embodiment of the semiconductor device of the present invention, the conductive through holes comprise a conductive film covering surfaces of the conductive through holes.

In one embodiment of the semiconductor device of the present invention, the conductive film is a thin metal film, and the material of the thin metal film is selected from the group consisting of beryllium (Be), gold (Au), aluminum (Al), platinum (Pt), iron (Fe), cobalt (Co), nickel (Ni), copper (Cu), zinc (Zn), silver (Ag), chromium (Cr), titanium (Ti) and their combinations.

In one embodiment of the semiconductor device of the present invention, the conductive film is a transparent conductive film, and the material of the transparent conductive film is selected from the group consisting of indium tin oxide (ITO), aluminum zinc oxide (AZO), zinc tin oxide (IZO), zinc oxide (ZNO), nickel oxide, indium tin oxide, cadmium tin oxide, antimony tin oxide and their combinations.

In one embodiment of the semiconductor device of the present invention, the conductive film includes an ion implantation film, and the material of the ion implantation film is selected from the group consisting of silicon (Si), tellurium (Te), antimony (Sb), magnesium (Mg), zinc (Zn), copper (Cu) and their combinations.

In one embodiment of the semiconductor device of the present invention, the current spreading composite layer includes at least one pair of a doped layer and an undoped layer stacked adjacent to each other.

In one embodiment of the semiconductor device of the present invention, the doped layer of the current spreading composite layer is a doped aluminum gallium indium phosphide (AlₓGa_{(0.5-x)}In_{0.5}P) layer, x=0.05~0.45, and the doped aluminum gallium indium phosphide layer is doped by silicon or tellurium with a doping concentration of 1.0E17/cm³~2.0E19/cm³.

In one embodiment of the semiconductor device of the present invention, the undoped layer of the current spreading composite layer is an undoped aluminum gallium indium phosphide (AlₓGa_{(0.5-x)}In_{0.5}P) layer, y≥x.

In one embodiment of the semiconductor device of the present invention, the total thickness of the current spreading composite layer is approximately 0.1~3 micrometers (µm), the thickness of the doped aluminum gallium indium phosphide layer is approximately 50~5000 angstroms(Å), the thickness of the undoped aluminum gallium indium phosphide layer is approximately 50~5000 angstroms(Å).

In one embodiment of the semiconductor device of the present invention, the materials of the first semiconductor layer, the light-emitting layer and the second semiconductor layer are selected from the group consisting of indium gallium phosphide (InGaP), aluminum gallium phosphide Indium (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), arsenide gallium (GaAs), gallium arsenide phosphide (GaAsP), indium gallium arsenide phosphide (InGaAsP) and their combinations.

In one embodiment of the semiconductor device of the present invention, the semiconductor device further comprises a plurality of dot-shaped conductive electrodes disposed in the insulation dielectric layer at the bottom of the second semiconductor layer and not vertically overlapping with the conductive through holes

After referring to the drawings and the detailed description of embodiments described later, those of ordinary skill in the art can understand other objectives of the present invention, as well as the technical means and implementations of the present invention.

### BRIEF DESCRIPTION OF THE DRAWINGS

FIG. 1 illustrates a schematic diagram of a light-emitting diode in one embodiment of the present invention;
FIG. 2 is a top view schematic diagram of the light-emitting diode device shown in FIG. 1;
FIG. 3 illustrates a schematic diagram of a light-emitting diode in another embodiment of the present invention;
FIG. 4 is a partially enlarged schematic diagram of the light-emitting diode in one embodiment of the present invention; and
FIG. 5 illustrates a schematic diagram of a light-emitting diode in another embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, partial elements not directly related to the present invention are omitted from the illustration, and dimensional proportions among individual elements and the numbers of each element in the accompanying drawings are provided only for ease of understanding but are not intended to limit the actual scale.

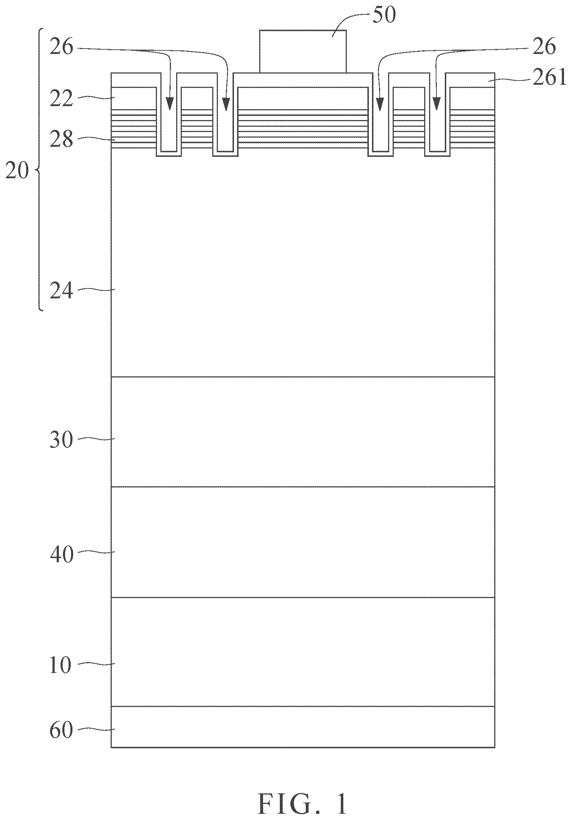

Please refer to FIG. 1, which discloses an embodiment of the semiconductor device of the present invention, particularly a schematic diagram of a light-emitting diode structure capable of uniform current spreading. As shown in the figure of this embodiment, the light-emitting diode comprises a substrate 10, a first semiconductor layer 20, a light-emitting layer 30, a second semiconductor layer 40, an upper electrode 50, and a lower electrode 60. The second semiconductor layer 40, the light-emitting layer 30, the first semiconductor layer 20, and the upper electrode 50 are sequentially disposed on the substrate 10, while the lower electrode 60 is disposed on another side of the substrate 10. In the embodiment of the present invention, the substrate 10 is a semiconductor substrate, which can be, but is not limited to, a silicon substrate, a silicon carbide substrate, an aluminum nitride substrate, a sapphire substrate, a gallium arsenide substrate, a gallium phosphide substrate, or an indium phosphide substrate. Additionally, the first semiconductor layer 20, the light-emitting layer 30, and the second semiconductor layer 40 are semiconductor epitaxial structures disposed on the substrate 10, and the materials constituting these epitaxial structures are selected from the group consisting of indium gallium phosphide (InGaP), aluminum gallium indium phosphide (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), gallium arsenide (GaAs), gallium arsenide phosphide (GaAsP), indium gallium arsenide phosphide (InGaAsP), and their combinations.

Please continue to refer to FIG. 1. In a specific embodiment, the second semiconductor layer 40 is a P-type semiconductor layer disposed on the substrate 10. For example, the second semiconductor layer 40 can be, but is not limited to, an aluminum gallium indium phosphide layer with a composition ratio of AlₓGa_{(0.5-x)}In_{0.5}P, where x=0~0.5, or a gallium phosphide layer (GaP). Dopant elements can be, but are not limited to, magnesium (Mg) or zinc (Zn), with a doping concentration of approximately 1.0E16/cm³~1.0E20/cm³. The thickness of the second semiconductor layer 40 can be, but is not limited to, 100~100000 angstroms (Å). The light-emitting layer 30 is formed by a multiple quantum well (MQW) structure. In this embodiment, the emission wavelength of the multiple quantum well can be in the range of 600~700 nanometers, but is not limited thereto.

On the other hand, the first semiconductor layer 20 is an N-type semiconductor. In a preferred embodiment, the first semiconductor layer 20 includes a first semiconductor upper layer 22, a first semiconductor lower layer 24, and a plurality of conductive through holes 26. The first semiconductor upper layer 22 can be, but is not limited to, an aluminum gallium indium phosphide layer with a composition ratio of AlₓGa_{(0.5-x)}In_{0.5}P, where x=0.05~0.45. Dopant elements can be, but are not limited to, silicon (Si) or tellurium (Te), with a doping concentration of approximately 1.0E17/cm³~2.0E19/cm³. The thickness of the first semiconductor upper layer 22 can be, but is not limited to, 100~100000 angstroms (Å). Additionally, the first semiconductor lower layer 24 can be, but is not limited to, an aluminum gallium indium phosphide layer with a composition ratio of AlₓGa_{(0.5-x)}In_{0.5}P, where x=0.05~0.5. Dopant elements can be, but are not limited to, silicon (Si) or tellurium (Te), with a doping concentration of approximately 1.0E17/cm³~2.0E19/cm³. The thickness of the first semiconductor lower layer 24 can be, but is not limited to, 100~100000 angstroms (Å).

It should be noted that in conventional techniques, in order to achieve current diffusion and increase brightness, the upper electrode of a light-emitting diode (LED) typically features a finger-shaped electrode branching design to ensure uniform current injection into the light-emitting layer for enhanced brightness. However, since the electrodes are usually made of metal, too many finger-shaped electrode branches may cause shading, thus hindering light extraction and reducing brightness. In view of this, one of the features of the present invention is that the upper electrode 50 is designed to have fingerless structures, i.e., the present invention utilizes a pin-shaped electrode design formed by a plurality of conductive through holes to replace the aforementioned finger-shaped electrode branches. As shown in FIG. 1, a plurality of conductive through holes 26 are arranged from top to bottom around the periphery of the upper electrode 50, uniformly distributed in the first semiconductor layer 20.

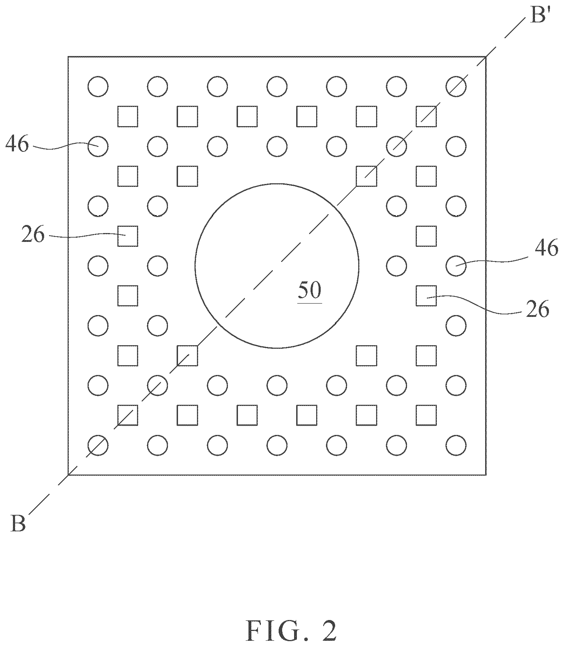

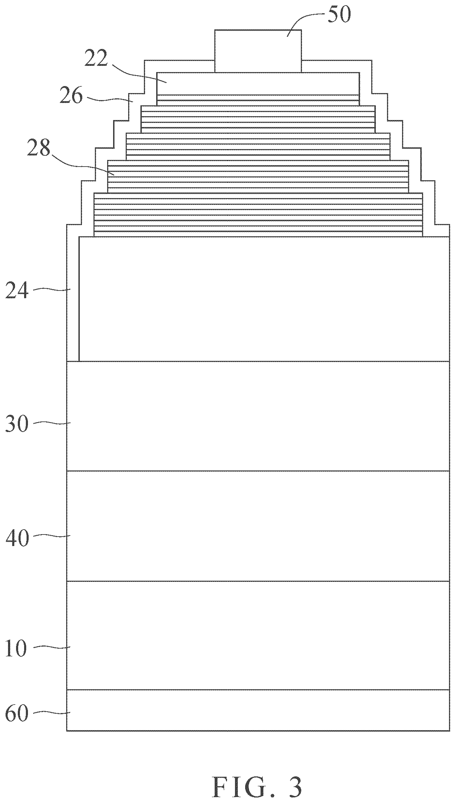

Specifically, each conductive through hole 26 vertically penetrates from the first semiconductor upper layer 22 to the first semiconductor lower layer 24 allowing the external current applied to the upper electrode 50 to flow through these conductive through holes 26 from the first semiconductor upper layer 22 to the first semiconductor lower layer 24 and connect electrically with the light-emitting layer 30. Moreover, to achieve the objective of current spreading, the plurality of conductive through holes 26 are uniformly distributed in the first semiconductor layer 20, as shown in FIG. 2, where FIG. 2 depicts a top view of the light-emitting diode device illustrated in FIG. 1, and FIG. 1 represents a cross-sectional schematic of the light-emitting diode structure along the BB' line in FIG. 2. The cross-sectional shape of each conductive through hole 26 can be circular, elliptical, square, or other shapes, but not limited thereto. It should be noted that the conductive through holes 26 are distributed in the internal region of the first semiconductor layer 20 of the light-emitting diode. Alternatively, as shown in FIG. 3, the conductive through holes 26 can also be distributed in the edge region of the first semiconductor layer 20 of the light-emitting diode for achieving the purpose of uniform current distribution and spreading. Whether distributed in the internal region or the edge region of the light-emitting diode, replacing the traditional finger-shaped electrode branching structure with conductive through holes effectively reduces the shading area of the upper electrode in this invention, and thereby, increases the light extraction efficiency accordingly.

Additionally, each conductive through hole 26 comprises a conductive film 261 covering the surface of each conductive through hole and the upper surface around the upper electrode 50 of the light-emitting diode, as shown in FIG. 1. For example, the conductive film 261 can be a transparent conductive film. The material of the transparent conductive film is selected from a group consisting of indium tin oxide (ITO), aluminum zinc oxide (AZO), zinc tin oxide (IZO), zinc oxide (ZNO), nickel oxide, indium tin oxide, cadmium tin oxide, antimony tin oxide, and their combinations. Alternatively, the conductive film 261 can also be a thin metal film, and the material of the thin metal film is selected from a group consisting of beryllium (Be), gold (Au), aluminum (Al), platinum (Pt), iron (Fe), cobalt (Co), nickel (Ni), copper (Cu), zinc (Zn), silver (Ag), chromium (Cr), titanium (Ti), and their combinations. In other embodiments, the conductive film 261 may include an ion implantation film or form conductive regions by ion diffusion, wherein the material of the ion implantation film is selected from a group consisting of silicon (Si), tellurium (Te), antimony (Sb), magnesium (Mg), zinc (Zn), copper (Cu), and their combinations.

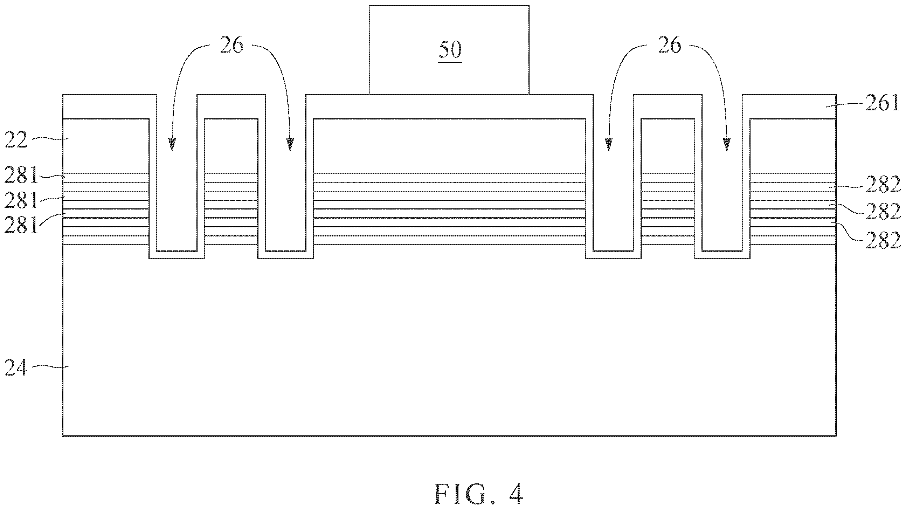

Preferably, referring to both FIG. 1 and FIG. 4, the first semiconductor layer 20 further includes a current spreading composite layer 28 sandwiched between the first semiconductor upper layer 22 and the first semiconductor lower layer 24. Moreover, the depth of the aforementioned conductive through holes 26 must penetrate at least through the current spreading structure 28 to electrically connect the first semiconductor upper layer 22 to the first semiconductor lower layer 24. As shown in FIG. 4, the current spreading composite layer 28 of the light-emitting diode of the present invention comprises at least one pair of doped layers 281 and undoped layers 282 stacked adjacent to each other. Specifically, in the embodiment of the current spreading composite layer 28 as shown in the figure, the doped layers 281 in odd-numbered layers (e.g., the 1st, 3rd, 5th... layers) are doped aluminum gallium indium phosphide (AlₓGa_{(0.5-x)}In_{0.5}P) layers, where x=0.05~0.45, and the doped aluminum gallium indium phosphide layer is doped with silicon (Si) or tellurium (Te) with a doping concentration of 1.0E17/cm³~2.0E19/cm³. The thickness of the doped layers 281 can be, but is not limited to, 50~5000 angstroms (Å). On the other hand, the undoped layers 282 in even-numbered layers (e.g., the 2nd, 4th, 6th... layers) are undoped aluminum gallium indium phosphide (Al_{y}Ga_{(0.5-y)}In_{0.5}P) layers, where y≥x. The thickness of the undoped layers 282 can be, but is not limited to, 50~5000 angstroms (Å), and the total thickness of the current spreading composite layer 28 is approximately 0.1~3 micrometers (µm).

As mentioned above, the resistance of the current spreading layer is related to factors such as doping concentration, semiconductor layer thickness, and composition materials. By appropriately controlling these influencing factors, the current flow can be effectively guided in the semiconductor layer to achieve uniform current spreading. For example, higher doping concentration leads to lower resistance. Alternatively, thicker doping layers also result in lower resistance. Therefore, lowering resistance in the doping layer can enhance lateral conduction. On the other hand, lower aluminum content in the aluminum gallium indium phosphide layer leads to lower resistance. Conversely, in the undoped semiconductor layer, due to the carrier concentration is much lower than that of doped semiconductors, the conductive properties of the undoped semiconductor layer are closer to those of insulators. Thicker layers have higher resistance, and higher aluminum content in the aluminum gallium indium phosphide layer also leads to higher resistance. Therefore, reinforcing the insulation effect in the undoped layer enhances longitudinal blocking, forcing the current to spread laterally. In summary, to achieve uniform current spreading and thereby increase the brightness of the light-emitting diode, the present invention involves the placement of multiple current spreading layers between the upper and lower layers of the N-type semiconductor. These layers alternate between high-doped and undoped characteristics for enhancing the effect of lateral conduction in the doped layers and the effect of longitudinal blocking in the undoped layers.

It should be noted that the designs by changing doping concentration or thickness for the current spreading layers mentioned above is only an example and not limited to it. The present invention does not impose restrictions on factors such as doping elements, doping concentration, or thickness. The key requirement is that the adjacent upper and lower diffusion layers have significant differences in doping concentration, leading to substantial differences in resistance. This creates a "longitudinal blocking and lateral conduction" spreading effect between the layers. As a result, after passing through the current spreading layers and before injecting into the light-emitting layer 30, the current can effectively spread uniformly.

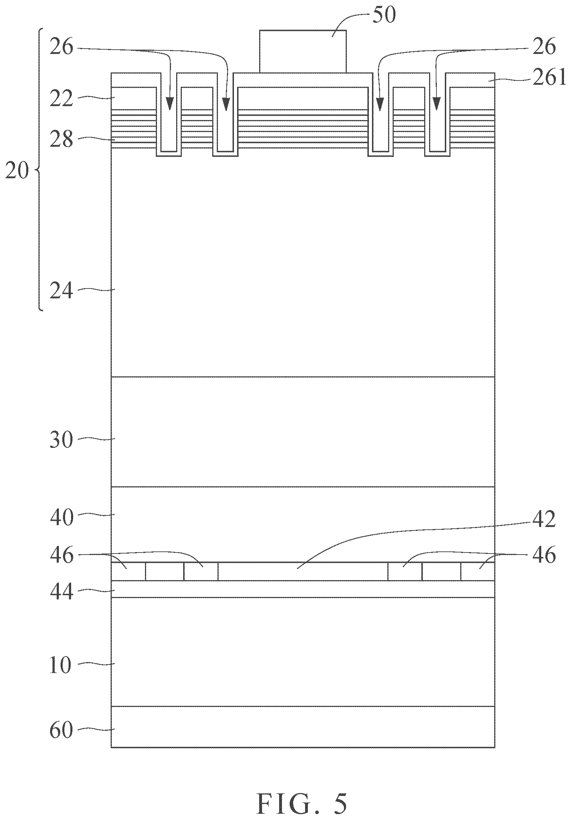

Please refer to both FIG. 2 and FIG. 5, where FIG. 5 illustrates another embodiment of the light-emitting diode according to the present invention. In order to enhance the current spreading effect and increase light extraction efficiency, in this embodiment, unlike the previous embodiment, an insulation dielectric layer 42 and a reflective metal layer 44 are placed at the bottom of the second semiconductor layer 40 of the light-emitting diode. By placing the dielectric layer 42 and the reflective metal layer 44, the light emitted from the light-emitting layer 30 is reflected upward, and thereby, the brightness will be increased. Additionally, a plurality of dot-shaped conductive electrodes 46 with ohmic contacts are arranged in the dielectric layer 42 to guide the current to the bottom electrode. Relative to the top electrode 50, these dot-shaped conductive electrodes 46 are distributed in a dot-like or strip-like manner around the periphery of the top electrode 50. Specifically, as shown in FIG. 2, these dot-shaped conductive electrodes 46 are disposed in a nonoverlapping manner with respect to each of the conductive through holes 26 in the vertical direction for allowing for a more uniform spreading of the current and achieving the goal of increasing brightness.

The above embodiments are used only to illustrate the implementations of the present invention and to explain the technical features of the present invention, and are not intended to limit the scope of the present invention. Any modifications or equivalent arrangements that can be easily accomplished by those skilled in this art are considered to fall within the scope of the present invention, and the scope of the present invention should be limited by the claims of the patent application.

## Claims

1. A semiconductor device, comprising:
a substrate;
an upper electrode;
a first semiconductor layer;
a light-emitting layer,
a second semiconductor layer, wherein the second semiconductor layer, the light-emitting layer, the first semiconductor layer and the upper electrode are sequentially disposed on the substrate; and
a plurality of conductive through holes, vertically disposed in the first semiconductor layer.

2. The semiconductor device of claim 1, wherein the upper electrode is electrically connected to the light-emitting layer through the conductive through holes.

3. The semiconductor device of claim 1, further comprising a current spreading composite layer, sandwiched in the first semiconductor layer, wherein the conductive through holes vertically penetrate the current spreading composite layer.

4. The semiconductor device of claim 1, wherein the conductive through holes are vertically disposed in one of an edge region and an inner region of the first semiconductor layer.

5. The semiconductor device of claim 1, wherein the conductive through holes comprise a conductive film covering surfaces of the conductive through holes.

6. The semiconductor device of claim 5, wherein the conductive film is a thin metal film, and the material of the thin metal film is selected from the group consisting of beryllium (Be), gold (Au), aluminum (Al), platinum (Pt), iron (Fe), cobalt (Co), nickel (Ni), copper (Cu), zinc (Zn), silver (Ag), chromium (Cr), titanium (Ti) and their combinations.

7. The semiconductor device of claim 5, wherein the conductive film is a transparent conductive film, and the material of the transparent conductive film is selected from the group consisting of indium tin oxide (ITO), aluminum zinc oxide (AZO), zinc tin oxide (IZO), zinc oxide (ZNO), nickel oxide, indium tin oxide, cadmium tin oxide, antimony tin oxide and their combinations.

8. The semiconductor device of claim 5, wherein the conductive film includes an ion implantation film, and the material of the ion implantation film is selected from the group consisting of silicon (Si), tellurium (Te), antimony (Sb), magnesium (Mg), zinc (Zn), copper (Cu) and their combinations.

9. The semiconductor device of claim 3, wherein the current spreading composite layer includes at least one pair of a doped layer and an undoped layer stacked adjacent to each other.

10. The semiconductor device of claim 9, wherein the doped layer of the current spreading composite layer is a doped aluminum gallium indium phosphide (AlₓGa_{(0.5-x)}In_{0.5}P) layer, x=0.05~0.45, and the doped aluminum gallium indium phosphide layer is doped by silicon or tellurium with a doping concentration of 1.0E17/cm³~2.0E19/cm³.

11. The semiconductor device of claim 10, wherein the undoped layer of the current spreading composite layer is an undoped aluminum gallium indium phosphide (AlₓGa_{(0.5-x)}In_{0.5}P) layer, y≥x.

12. The semiconductor device of claim 11, wherein the total thickness of the current spreading composite layer is approximately 0.1~3 micrometers(µm), the thickness of the doped aluminum gallium indium phosphide layer is approximately 50~5000 angstroms(Å), the thickness of the undoped aluminum gallium indium phosphide layer is approximately 50~5000 angstroms(Å).

13. The semiconductor device of claim 1, wherein the materials of the first semiconductor layer, the light-emitting layer and the second semiconductor layer are selected from the group consisting of indium gallium phosphide (InGaP), aluminum gallium phosphide Indium (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), arsenide gallium (GaAs), gallium arsenide phosphide (GaAsP), indium gallium arsenide phosphide (InGaAsP) and their combinations.

14. The semiconductor device of claim 1, further comprising a plurality of dot-shaped conductive electrodes disposed in the second semiconductor layer and not vertically overlapping with the conductive through holes.
